# EUROPEAN PATENT SPECIFICATION

(11) **EP 0 711 102 B1**
(45) Date of publication and mention of the grant of the patent: **27.09.2000**
(21) Application number: 94915265.6
(22) Date of filing: 18.05.1994
(51) Int. Cl.: H05K 3/18, H05K 3/08, H05K 3/24

(54) **METHOD FOR FORMING A CONDUCTIVE CIRCUIT ON THE SURFACE OF A MOLDED PRODUCT**
VERFAHREN ZUR HERSTELLUNG EINER LEITENDEN SCHALTUNG AUF DER OBERFLÄCHE EINES FORMKÖRPERS
PROCEDE DE REALISATION D'UN CIRCUIT CONDUCTEUR SUR LA SURFACE D'UN PRODUIT MOULE

(43) Date of publication of application: 08.05.1996
(73) Proprietor: POLYPLASTICS CO. LTD., Chuo-Ku Osaka-shi Osaka 541 (JP)
(72) Inventor: MIYASHITA, Takayuki, Shizuoka 416 (JP)
(74) Representative: Jackson, Peter
(86) International application number: JP9400799
(87) International publication number: WO9531884

(56) References cited:
- EP-A- 0 543 045
- JP-A- 4 263 490
- JP-A- 61 026 287
- JP-A- 63 169 791
- JP-A- 63 283 185
- JP-B- 60 008 592
- US-A- 4 898 648

## Description

### Field of the Invention

This invention relates to a process for forming a conductive circuit on the surface of a molded article of a synthetic resin, and more particularly to a process for manufacturing a molded article having an accurate conductive circuit on the surface thereof for use as a circuit component in electric and electronic machines.

### Related Art

There is a SKW process or a PCK process, a conventional process for forming a circuit on the surface of a molded article, in which an article body is doubly molded by using, for example, two kinds of materials having different plating properties, a portion on which a circuit is to be formed of the article body being selectively plated by utilizing a difference between the plating properties of this portion and those of the other portion, so as to form a metallic circuit. However, these processes require two molding steps, so that they become complicated and uneconomical. Moreover, it is difficult to improve the adhesion of the interface of the two kinds of resins, and thus a plating liquid may enter and remain.

In a conventional circuit forming process using photoresist and having many steps including a photoresist coating step, a circuit pattern exposing step, a circuit pattern developing step, a copper etching step and a photoresist removing step, the forming of circuits becomes complicated. Moreover, in order to form a three-dimensional conductive circuit on the surface of a three-dimensional molded article, a circuit which meets the purpose to a certain extent can be obtained by parallel-ray projection exposure but this process has a problem concerning the accuracy of the circuit. In addition, there is a limit to the solving of this problem when a substrate in use has a certain three-dimensional shape.

A circuit forming process using a laser beam is being developed in recent years. For example, a process having the steps of forming a metallic film of a sufficient thickness as a conductive circuit on the surface of a molded article, and then driving off in small pieces the portion of the metallic film which is not to be used as a conductive circuit with a laser beam to obtain a conductive circuit directly has been devised. This process does not need double molding or photoresist coating, and is practised very simply. However, it is necessary in this process to form a conductive metallic layer thick enough (for example, more than 10 µm) to obtain a sufficiently high conductivity. Accordingly, when an unnecessary part of such a metallic layer is removed with a laser beam, the output level thereof has to be increased. Therefore, even a molded article of a synthetic resin which constitutes a base material is damaged, and the external appearance of a product is greatly spoiled. Moreover, the synthetic resin is carbonized and deteriorated in insulation.

EP-A-0 287 843 describes and claims a circuit-forming process in which the conductive material is applied to an electrically insulating substrate by seeding, activation and subsequent chemical or chemical and galvanic deposition of metal, in which the seed layer, either alone or together with a thin chemically deposited metal base layer, is removed by electromagnetic radiation from regions of the substrate which are not to be conducting elements. The conductive material is then applied by chemical and/or galvanic metal deposition.

The present inventors have discussed thoroughly a simple process for forming a circuit accurately, even on a molded article of a complicated shape, which is capable of solving the problems involved in these conventional processes, and, especially, a process for forming a conductive circuit by utilizing a laser beam, so as to solve the above-mentioned problems, and they have discovered that, when a laser beam of a lower output level is applied to a metallic layer formed in advance on the surface of a molded article of a synthetic resin to a thickness greater than a predetermined level, an unnecessary part of the metallic layer can be removed selectively to enable a circuit pattern to be formed without damaging the ground resin, and that, when a metallic layer of a desired thickness is then formed on this circuit pattern by electric plating, a desired conductive circuit can be formed comparatively simply without spoiling the external appearance, shape and heat insulating characteristics of the product. The inventors have achieved the present invention on the basis of these discoveries.

Namely, the present invention is directed to a process for forming a conductive circuit on the surface of a metal-coatable molded article of a synthetic resin, comprising the steps of
(i) forming a thin metal film on the surface of the article by a method selected from chemical plating, sputtering, vacuum deposition, ion plating, transfer and coating of conductive material;
(ii) forming a circuit pattern from the thin metal film by applying a laser beam to the portion of the film other than the portion which is to form the circuit pattern while not damaging the so-exposed surface of the resin, and then
(iii) electrically plating the surface of the thin metal film constituting the circuit pattern, to form a conductive circuit of a desired thickness, characterised in that the resin comprises a liquid crystalline polymer or a composition thereof and in that the thin metal film is formed to a thickness in the range 0.2 to 2 µm and the laser beam is supplied by a laser having a computer-controlled XY scanning unit.

The process according to the present invention will now be described in order with reference to the drawings.

The material for a molded article used in the present invention comprises a liquid crystalline polymer, being a synthetic resin material to which a metallic film can be deposited firmly. Since the molded article is subjected to a severe treatment, such as soldering, it is required that the material has a high heat resistance and a high mechanical strength. Prom the point of view of mass production, such resin is suitable for injection molding. In view of the fact that the use of a synthetic resin having a high melting point, a high strength, a high rigidity and a moldability is required, a liquid crystalline polymer (for example, liquid crystalline polyester and polyester amide) is specially usable in the present invention. A suitable substance may be mixed with this materials as necessary so as to increase the adhesion of a metallic film.
Fig. 1 is a sectional view of a substrate molded article which is to become a three-dimensional molded circuit component as an example of the present invention.
Fig. 2 is a sectional view showing the condition of the substrate molded article of Fig. 1 the surface of which was chemical copper plated to form a copper film thereon.
Fig. 3 is a sectional view showing the condition of the chemical copper plated molded article of Fig. 2 in which the portion of the chemical copper film which is other than the portion thereof for forming a circuit thereon is removed by using a YAG laser, and in which a circuit pattern is then formed on the copper film.
Fig. 4 is a sectional view showing the condition of the circuit pattern-carrying molded article of Fig. 3 which is subjected to electric copper plating to form a circuit consisting of a metallic layer of a desired thickness.

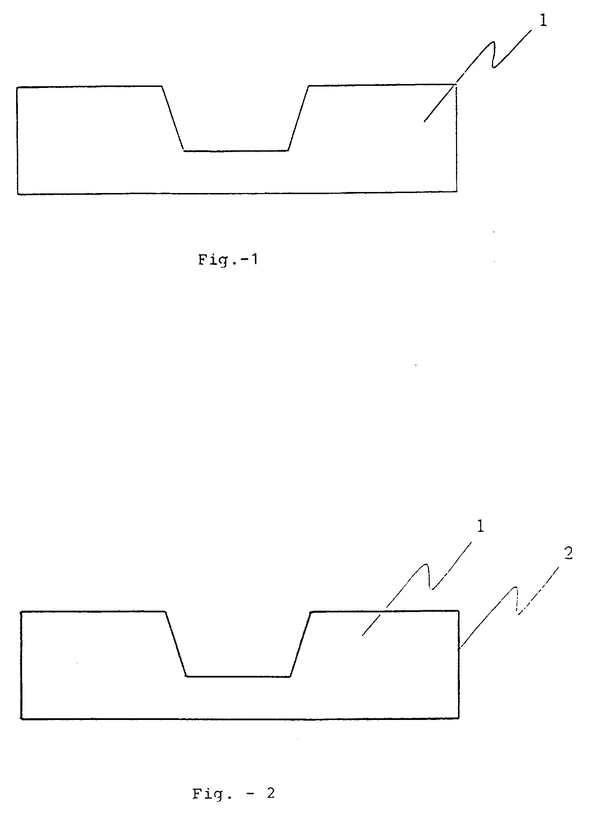

In the above-described Figs. 1 to 4, 1 represents substrate molded article; 2 represents copper film formed by chemical copper plating; 3 represents circuit pattern formed by using a laser beam; 4 represents conductive circuit formed by electric copper plating; 5 represents laser beam, respectively.

A substrate molded article (Fig. 1) is formed by injection molding, and in order to improve the adhesion of a metallic film on the surface thereof, the molded article may be further subjected to a physical surface treatment, such as chemical etching using acid, alkali and the like, or corona discharge and a plasma treatment.

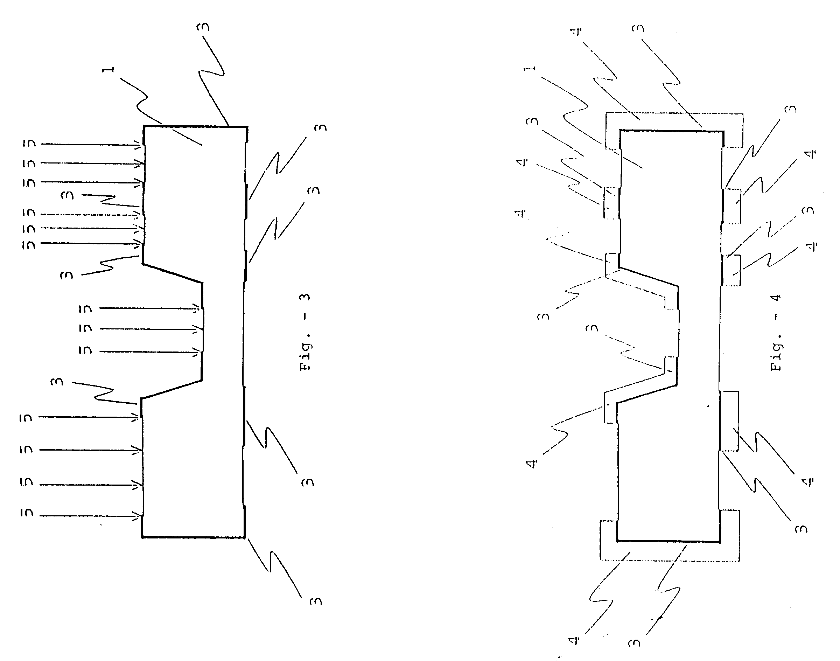

The surface of this molded article is then subjected to metal coating to form a metallic film thereon (Fig. 2). The thickness of metallic coating is especially important. When it is too thick, a high-power laser beam is required in a subsequent step of forming a circuit pattern and it may damage a molded article substrate as mentioned previously. Conversely, when it is too thin, trouble would occur in the formation of a metallic layer of a sufficient thickness thereon as a conductive circuit by electric plating in a final step. In view of this, the thickness of a metallic film on the surface of a molded article should be 0.2-2 µm, and preferably 0.3-1 µm. When a metallic film has a thickness in these ranges, a circuit pattern can be formed accurately by set without damage by using a laser beam of comparatively low power, and sufficient conductivity required for the electric plating for the formation of a final circuit can be maintained. A method of forming such a metallic film may consist of any of the known ones including chemical plating, sputtering, vacuum deposition, ion plating, transfer and coating of conductive material, and, in order to form a uniform metallic film, chemical plating (electroless plating), sputtering, ion plating and vacuum deposition are suitably used.

A laser beam of suitably regulated output is then applied to the part of the surface of the metallic film formed on the molded article (Fig. 2) which is other than a part thereof on which a circuit is to be formed, to selectively sputtering the same part of the film and obtain a circuit pattern of metallic film (Fig. 3). For this purpose, a YAG laser or carbon dioxide laser may be used to emit a laser beam having a wavelength in an infrared region, and a predetermined circuit pattern is selectively irradiated with a beam from a laser marker having a computer-controlled XY scanning unit. When it is necessary to form a circuit on a complicated three-dimensional molded article, a predetermined region thereof can be irradiated with a laser beam three-dimensionally with a high accuracy by a computer controlling means with the laser beam guided in a three-dimensional direction by an optical fiber or a prism. This process is advantageous in that the preparation and correction of a pattern can be carried out simply by merely changing a program of drawing an image on a region to which a laser beam is to be applied.

A molded article on which a circuit pattern of a metallic film is formed may be used as it is as a circuit component if it can meet the purpose of use thereof. However, in general, a film circuit thinner than 2 µm mentioned above involves inconveniences in many cases from the point of view of its conductivity or the possibility of damage ascribed to friction, and it is required to have a thickness of at least 10 µm in general cases. Therefore, according to the present invention, the surface of this circuit pattern is further subjected to electric plating to add a metallic layer of a desired thickness (for example, 10-100 µm) thereto, whereby a final circuit (Fig. 4) is formed. Since an already-formed circuit pattern has such a degree of conductivity that permits the same pattern to be electrically plated, a generally-used electric plating method can be applied to the additional formation of this metallic layer.

According to the present invention, complicated complex molding which is carried out in the SKW process and PCK process is not required, nor does it require the complicated steps carried out in a darkroom, such as the exposure and development of a circuit pattern in a process using photoresist. Moreover, it is possible to avoid, damage to a molded article by a laser beam, which may degrade the external appearance, shape and insulation. Therefore, a molded article having a precise conductive circuit of a desired thickness can be obtained by simple steps, so that this process is advantageous in the economical respect as well.

### Embodiment

An embodiment of the present invention will now be described with reference to the drawings. The present is not limited to the embodiment.

### Example 1

A three-dimensional molded article 1 was prepared (Fig. 1) by injection molding a metal-adhesive (chemically platable) resin composition containing as a main component liquid crystalline polyester ("Vectra"® manufactured by the Polyplastics Co., Ltd.). This molded article was then degreased, and the substantially whole surface of the resultant product was etched with aqueous KOH solution, the etched product being neutralized with an aqueous HCl solution and then washed. A catalyst ("Catalyst A-30"™ manufactured by the Okuno Seiyaku Kogyo Co., Ltd.) was applied to the washed product to activate the surface thereof, and the resultant product was immersed in a chemical copper plating liquid (OPC-750™ manufactured by the Okuno Seiyaku Kogyo Co., Ltd.) to form a chemical copper layer 2 of 0.6 µm in thickness on the surface of the molded article. The resultant molded article was washed thoroughly and thereafter dried (Fig. 2).

A laser beam from a 0.5-watt YAG laser 5 was applied to the molded article (Fig. 2) the surface of which had been chemical copper plated to remove the part of the copper film which was other than a part thereof on which a circuit was to be formed, whereby a circuit pattern 3 was formed (Fig. 3).

The molded article (Fig. 3) on which this circuit pattern had been formed was subjected to electric copper plating to obtain a precise three-dimensional conductive circuit 4 of a copper film of 30 µm in thickness (Fig. 4). It was ascertained that the exposed resin surface portion of this molded article which was other than the circuit portion thereof was not substantially damaged.

### Comparative Example 1

A molded article having a 5 µm copper film was prepared in the same manner as in Example 1 except that the thickness of a chemical capper layer on the surface of the molded article was set to 5 µm. A circuit pattern was tried to be formed on this molded article by using a 0.6-watt laser beam as was used in Example 1, but the output level of the laser beam was too low for the thickness of the copper film, so that it was difficult to form a circuit pattern on the film. When the output level of the laser beam was increased gradually, the forming of a circuit pattern became possible but a precise circuit pattern could not be obtained. Moreover, the base surface of the resin was damaged.

### Comparative Example 2

The surface of a molded article was subjected to chemical copper plating (to obtain a 0.6 µm film) by the same process as was used in Example 1, and then electric copper plating to coat the whole surface of the molded article with a 30 µm thick copper film. This electrically plated molded article was irradiated with a 5 to 15-watt laser beam from a YAG laser, but the copper film could not be completely removed, so that the formation of a circuit pattern could not be carried out. When the output level of the laser beam was increased until the copper plating could be removed. As a result, it was ascertained that the exposed base surface of the resin was damaged (carbonized) so greatly that the resultant product could not be used as a circuit component.

## Claims

1. A process for forming a conductive circuit on the surface of a metal-coatable molded article (1) of a synthetic resin, comprising the steps of:
(i) forming a thin metal film (2) on the surface of the article (1) by a method selected from chemical plating, sputtering, vacuum deposition, ionic plating, transfer and coating of conductive material;
(ii) forming a circuit pattern (3) from the thin metal film (2) by applying a laser beam (5) to the portion of the film other than the portion which is to form the circuit pattern (3) so as to remove the portion to which the laser beam (5) is applied while not damaging the so-exposed surface of the resin, and then;
(iii) electrically plating the surface of the thin metal film (2) constituting the circuit pattern (3), to form a conductive circuit (4) having a desired thickness, characterised in that the resin comprises a liquid crystalline polymer or a composition thereof and in that the thin metal film (2) is formed to a thickness in the range 0.2 to 2 µm and the laser beam (5) is supplied by a laser having a computer-controlled XY scanning unit.

2. A process as claimed in Claim 1, in which the resin is selected from a liquid crystalline polyester and a liquid crystalline polyesteramide.

3. A process as claimed in claim 1 or claim 2, in which the article has a nonplanar surface.

4. A process as claimed in any preceding claim, in which the step (iii) is effected so that the thickness of the conductive circuit (4) is between 10 and 100 µm.

5. A process as claimed in any preceding claim, in which the metal is copper.

## Patentansprüche

1. Verfahren zur Herstellung eines Schaltkreises auf der Oberfläche eines metallbeschichtbaren, geformten Gegenstandes (1) aus einem synthetischen Harz, umfassend die Stufen:
(i) der Bildung eines dünnen Metallfilms (2) auf der Oberfläche des Gegenstandes (1) durch ein Verfahren, das aus dem chemischen Plattieren, Sputtern, Vakummabscheiden, ionischen Plattieren, Übertragen und Auftragen von leitfähigem Material ausgewählt ist;
(ii) der Bildung eines Schaltkreismusters (3) aus dem dünnen Metallfilm (2) durch Anwenden eines Laserstrahls (5) auf den Teil des Films, der von dem Teil verschieden ist, welcher der Bildung des Schaltkreismusters (3) dient, um somit den Teil zu entfernen, auf den der Laserstrahl (5) angewendet wurde, wobei die somit belichtete Oberfläche des Harzes nicht beschädigt wird; und anschließend
(iii) des elektrischen Plattierens der Oberfläche des dünnen Metallfilms (2), der das Schaltkreismuster (3) ausmacht, um einen Schaltkreis (4) einer erwünschten Dicke zu bilden, dadurch gekennzeichnet, daß das Harz ein flüssig-kristallines Polymer oder eine Zusammensetzung desselben umfaßt, und der dünne Metallfilm (2) mit einer Dicke im Bereich von 0,2 bis 2 µm gebildet wird, und der Laserstrahl (5) durch einen Laser bereitgestellt wird, der eine Computer-gesteuerte XY-Scanning-Einheit aufweist.

2. Verfahren gemäß Anspruch 1, worin das Harz aus einem flüssig-kristallinen Polyester und einem flüssig-kristallinen Polyesteramid ausgewählt ist.

3. Verfahren gemäß den Ansprüchen 1 oder 2, worin der Gegenstand eine nichtplanare Oberfläche aufweist.

4. Verfahren gemäß irgendeinem der vorhergehenden Ansprüche, worin die Stufe (iii) derartig ausgeführt wird, daß die Dicke des Schaltkreises (4) zwischen 10 und 100 µm liegt.

5. Verfahren gemäß irgendeinem der vorhergehenden Ansprüche, worin das Metall Kupfer ist.

## Revendications

1. Un procédé pour former un circuit conducteur sur la surface d'un article moulé métallisable (1) constitué d'une résine synthétique, comprenant les étapes de :
(i) formation d'une couche mince de métal (2) sur la surface de l'article (1) par une technique choisie parmi le dépôt chimique, la pulvérisation cathodique, le dépôt sous vide, le dépôt ionique, le transfert et l'application de matière conductrice ;
(ii) formation d'un motif de circuit (3) à partir de la couche mince de métal (2) par application d'un faisceau laser (5) à la partie de la couche autre que la partie devant former le motif de circuit (3), afin d'éliminer la partie à laquelle le faisceau laser (5) est appliqué, sans endommager la surface ainsi découverte de la résine ; puis
(iii) métallisation électrique de la surface de la couche mince de métal (2) constituant le motif de circuit (3) pour former un circuit conducteur (4) ayant une épaisseur désirée,
caractérisé en ce que la résine comprend un polymère à phase cristalline liquide ou une composition de celui-ci et en ce que la couche mince de métal (2) est formée en une épaisseur comprise dans l'intervalle de 0,2 à 2 µm et le faisceau laser (5) est délivré par un laser associé à un système de balayage XY piloté par ordinateur.

2. Un procédé tel que revendiqué dans la revendication 1, dans lequel la résine est choisie parmi un polyester à phase cristalline liquide et un polyesteramide à phase cristalline liquide.

3. Un procédé tel que revendiqué dans la revendication 1 ou la revendication 2, dans lequel l'article a une surface non plane.

4. Un procédé tel que revendiqué dans l'une quelconque des revendications précédentes, dans lequel l'étape (iii) est exécutée de telle façon que l'épaisseur du circuit conducteur (4) soit comprise entre 10 et 100 µm.

5. Un procédé tel que revendiqué dans l'une quelconque des revendications précédentes, dans lequel le métal est le cuivre.
